(19) Europäisches Patentamt
European Patent Office
Office européen des brevets

(11) **EP 3 155 145 B1**

(12) # EUROPÄISCHE PATENTSCHRIFT

(45) Veröffentlichungstag und Bekanntmachung des Hinweises auf die Patenterteilung:
**13.04.2022   Patentblatt 2022/15**

(21) Anmeldenummer: **15726035.7**

(22) Anmeldetag: **18.05.2015**

(51) Internationale Patentklassifikation (IPC):
**C30B 25/02** (2006.01)   **C30B 25/18** (2006.01)
**C30B 29/52** (2006.01)   **C30B 29/40** (2006.01)
**C30B 29/48** (2006.01)   **C30B 29/10** (2006.01)
**H01L 21/02** (2006.01)   **C09K 11/66** (2006.01)

(52) Gemeinsame Patentklassifikation (CPC):
**C09K 11/66; C30B 25/02; C30B 25/183;
C30B 29/10; C30B 29/52; H01L 21/02381;
H01L 21/0245; H01L 21/02452; H01L 21/02505;
H01L 21/02532; H01L 21/02535; H01L 21/0262**

(86) Internationale Anmeldenummer:
**PCT/EP2015/060881**

(87) Internationale Veröffentlichungsnummer:
**WO 2015/189004 (17.12.2015 Gazette 2015/50)**

(54) **VERFAHREN ZUM ABSCHEIDEN EINES OPTOELEKTRONISCHEN BAUELEMENTS MIT EINER EINKRISTALLINEN SI-GE-SN HALBLEITERSCHICHT UND DERARTIGES OPTOELEKTRONISCHES BAUELEMENT**

METHOD FOR DEPOSITING AN OPTOELECTRONIC COMPONENT WITH A SINGLE CRYSTALLINE SI-GE-SN SEMICONDUCTING LAYER AND OPTOELECTRONIC COMPONENT WITH SUCH A LAYER

PROCÉDÉ DE DÉPÔT D'UN DISPOSITIF OPTOÉLECTRONIQUE AVEC UNE COUCHE DE SEMI-CONDUCTEUR DE SI-GE-SN MONOCRISTALLIN ET UN TEL DISPOSITIF OPTOÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.06.2014   DE 102014108352**

(43) Veröffentlichungstag der Anmeldung:
**19.04.2017   Patentblatt 2017/16**

(73) Patentinhaber: **Forschungszentrum Jülich GmbH 52425 Jülich (DE)**

(72) Erfinder:
• **GRÜTZMACHER, Detlev**
  **52382 Niederzier (DE)**
• **WIRTHS, Stephan**
  **52062 Aachen (DE)**
• **BUCA, Dan Mihai**
  **52428 Jülich (DE)**
• **MANTL, Siegfried**
  **52428 Jülich (DE)**

(74) Vertreter: **Grundmann, Dirk et al Rieder & Partner mbB Patentanwälte - Rechtsanwalt Yale-Allee 26 42329 Wuppertal (DE)**

(56) Entgegenhaltungen:
US-A1- 2010 273 318     US-A1- 2013 280 891
US-A1- 2014 020 619

• **S. WIRTHS ET AL: "SiGeSn growth studies using reduced pressure chemical vapor deposition towards optoelectronic applications", THIN SOLID FILMS, Bd. 557, 1. April 2014 (2014-04-01), Seiten 183-187, XP055204907, ISSN: 0040-6090, DOI: 10.1016/j.tsf.2013.10.078 in der Anmeldung erwähnt**

- S. WIRTHS ET AL: "Reduced Pressure CVD Growth of Ge and Ge1-xSnx Alloys", ECS JOURNAL OF SOLID STATE SCIENCE AND TECHNOLOGY, Bd. 2, Nr. 5, 5. März 2013 (2013-03-05), Seiten N99-N102, XP055204908, ISSN: 2162-8769, DOI: 10.1149/2.006305jss in der Anmeldung erwähnt
- S. WIRTHS ET AL: "Epitaxial Growth of Ge1-xSnx by Reduced Pressure CVD Using SnCl4 and Ge2H6", ECS TRANSACTIONS, Bd. 50, Nr. 9, 15. März 2013 (2013-03-15), Seiten 885-893, XP055204910, ISSN: 1938-6737, DOI: 10.1149/05009.0885ecst in der Anmeldung erwähnt
- SOREF R ET AL: "Advances in SiGeSn technology", JOURNAL OF MATERIALS RESEARCH, MATERIALS RESEARCH SOCIETY, WARRENDALE, PA, US , vol. 22, no. 12 1 December 2007 (2007-12-01), pages 3281-3291, XP009127829, ISSN: 0884-2914, DOI: 10.1557/JMR.2007.0415 Retrieved from the Internet: URL:http://www.mrs.org/publications/jmr/ [retrieved on 2016-05-18]
- SHARP J W ET AL: "In situ observation of surface-limited Ge growth processes by transient optical reflectometry", JOURNAL OF CRYSTAL GROWTH, ELSEVIER, AMSTERDAM, NL, vol. 125, no. 3-4, 1 December 1992 (1992-12-01), pages 553-567, XP024438561, ISSN: 0022-0248, DOI: 10.1016/0022-0248(92)90296-U [retrieved on 1992-12-01]
- F. GENCARELLI ET AL: "Low-temperature Ge and GeSn Chemical Vapor Deposition using Ge2H6", THIN SOLID FILMS, vol. 520, no. 8, 1 February 2012 (2012-02-01), pages 3211-3215, XP055615436, AMSTERDAM, NL ISSN: 0040-6090, DOI: 10.1016/j.tsf.2011.10.119 [retrieved on 2019-08-28]

**Beschreibung**

Die Erfindung betrifft ein Verfahren zum Abscheiden eines SiGeSn- Halbleiterkristalls, welcher als Folge eines direkten elektronischen Bandübergangs bei einer Anregung, beispielsweise durch Anlegen einer Spannung oder durch Einkoppeln von Licht im sichtbaren, infraroten oder ultravioletten Licht leuchtet.

Die Erfindung betrifft darüber hinaus ein optoelektronisches Bauelement, welches eine aus einem derartigen Kristall bestehende Schicht aufweist, sowie einen integrierten Schaltkreis, der ein derartiges Bauelement aufweist.

Aus "DEPOSITION OF HIGH QUALITY GaAs FILMS AT FAST RATES IN THE LP-CVD SYSTEM", Journal of crystal grows 94 (1989) 607-612 ist das Abscheiden von Galliumarsenid-Schichten vorbekannt. Gallium wird in Form eines Chlorides und Arsen in Form eines Hydrides in eine Prozesskammer eingeleitet. Die Wachstumsrate nimmt mit sinkender Temperatur und mit sinkendem Totaldruck ab. Die Abhängigkeit der Wachstumsrate vom Totaldruck hat bei etwa 100 mbar ein Minimum und steigt zu tieferen Totaldrücken bis 10 mbar um mehr als einen Faktor 10 an.

Die Mehrzahl der technologisch verwendeten Halbleiterbauelemente und insbesondere integrierten Schaltkreise, insbesondere Logikschaltkreise oder in Mikroprozessoren verwendete Schaltkreise werden mit der Siliziumtechnologie hergestellt. Zur Verwendung kommt ein Siliziumsubstrat, auf dem dotierte oder undotierte Siliziumschichten bzw. Siliziumoxidschichten abgeschieden werden. Trotz der voneinander verschiedenen Gitterkonstanten ist es auch möglich, andere IV-IV Legierungen kristallin auf einem Siliziumkristall abzuscheiden, beispielsweise Germanium oder Germaniumzinn. Ein technologischer Nachteil bislang hergestellter IV-IV Kristalle ist das Fehlen eines direkten elektronischen Bandübergangs. Sowohl Silizium als auch Germanium, aber auch thermodynamisch stabiles Germaniumzinn oder Siliziumzinn besitzen keinen direkten Bandübergang, der zur Fertigung von optisch aktivierbaren Bauelementen, beispielsweise LEDs oder Laser, tauglich ist.

Es wird vermutet, dass eine unverspannte Germaniumzinn-Legierung als Kristall außerhalb des thermodynamischen Gleichgewichtes, nämlich bei Zinnkonzentrationen von mindestens etwa 20 % einen direkten Bandübergang haben könnte. Die Gleichgewichtszinnkonzentration in einer Germaniumzinn-Legierung liegt aber bei weniger als 1 %. Es wird vermutet, dass eine Zunahme der Zinnkonzentration unter Bildung eines thermodynamisch metastabilen Kristalls zu einer Absenkung des Leitungsbandes im Bereich des $\Gamma$-Tals führen würde, die stärker ist als die Absenkung des Leitungsbandes im L-Tal. Im $\Gamma$-Tal würde sich dann ein direkter Bandübergang ausbilden, der dem Kristall die gewünschten optischen Eigenschaften verleihen würde.

In "SiGeSn growth studies using reduced pressure chemical vapor deposition towards optoelectronic applications" in Thin Solid Films 2013 (S. Wirths, et al., Thin Solid Films (2013), http://dx.doi.org/10.1016/j.tsf.2013.10.078) wird das Abscheiden von Germaniumzinn- bzw. Siliziumgermaniumzinn-Schichten auf Siliziumsubstraten bzw. auf Germaniumbufferschichten beschrieben. Die dort abgeschiedenen, 45 nm bzw. 65/100 nm dicken Schichten mit einem Sn-Anteil von maximal 11 % zeigten keine Lumineszens. Es wurde ein pseudomorphes Wachstum gefunden. Die dort beschriebenen Experimente wurden bei Substrattemperaturen zwischen 350° C und 475° C durchgeführt. Als Prozessgase wurden $Si_2H_6$ (60 Pa), $Ge_2H_6$ (120 Pa) und $SnCl_4$ (0,6 Pa) verwendet.

In "Reduced Pressure CVD Growth of Ge and Ge1-xSnx Alloys" (ESC Journal of Solid State Science and Technology, 2(5) N99-N102 (2013)) wird der experimentelle Aufbau eines CVD-Reaktors beschrieben, mit dem Germaniumschichten auf Siliziumsubstraten bzw. Germaniumzinn-Schichten auf Siliziumsubstraten abgeschieden werden können.

Zum Stand der Technik gehören darüber hinaus auch folgende Veröffentlichungen, die das Abscheiden nicht lumineszierender GeSn-Schichten beschreiben:

"Band engineering and growth of tensile strained Ge/ (Si)GeSn heterostructures for tunnel field effect transistors" (Applied Physics Letters 102, 192103 (2013)),

"Tensely strained GeSn alloys as optical gain media" (Applied Physics Letters 103, 192110 (2013)),

"Low temperature RPCVD epitaxial growth of Si1-xGex using Si2H6 and Ge2H6" (Solid-State Electronics 83 (2013) 2-9),

"Epitaxial Growth of Ge1-xSnx by Reduced Pressure CVD Using SnCl4 and Ge2H6" (ECS Transactins, 50 (9) 885-893 (2012) © The Electrochemical Society).

Eine Vorrichtung zum Abscheiden von Silizium und Germanium enthaltenden Schichten bzw. Schichtenfolgen wird in der DE 10 2004 034 103 A1 beschrieben. Die Verwendung von Radikalen in einem CVD-Prozess ist aus der US 6,200,893 vorbekannt.

Der Erfindung liegt die Aufgabe zugrunde, Kristalle bei niedrigen Temperaturen, insbesondere außerhalb ihres thermodynamischen Gleichgewichtes abzuscheiden, insbesondere optisch aktive bzw. aktivierbare IV-Halbleiterschichten abzuscheiden, um die monolithische Integration optisch aktiver Bauelemente auf Siliziumsubstraten zu ermöglichen.

Gelöst wird die Aufgabe durch die in den Ansprüchen angegebene Erfindung. Die Erfindung betrifft ein Verfahren zum Abscheiden einer kristallinen Halbleiterschicht. Die Halbleiterschicht soll zumindest aus einem oder mehreren Elementen bestehen. Die ein oder mehreren Elemente werden als Bestandteile gasförmiger Ausgangsstoffe zusammen mit einem inerten Trägergas in eine Prozesskammer eines CVD-Reaktors eingespeist. Der erste gasförmige Ausgangsstoff kann ein Hydrid sein, beispielsweise $Si_2H_6$, Der zweite gasförmige Ausgangsstoff ist $SnCl_4$. Das Trägergas kann $N_2$, Ar, He sein, sollte aber kein $H_2$ sein. Die Vorrichtung zur Durchführung des Verfahrens besitzt bevorzugt ein Gaseinlassorgan, beispielsweise in Form eines Showerheads. Dieser besitzt eine oder mehrere Gasverteilkammern, die jeweils eine Vielzahl von Gasaustrittsöffnungen aufweisen, die in eine Prozesskammer münden. Durch die Gasaustrittsöffnungen können die Prozessgase in die Prozesskammer strömen. Das Gaseinlassorgan wird gekühlt um eine dortige Vorzerlegung der Ausgangsstoffe zu vermeiden. Der Abscheidungsprozess erfolgt im Niedrigdruckbereich, also bei Drucken niedriger als 300 mbar, niedriger als 200 mbar, niedriger als 100 mbar oder bevorzugt bei 60 mbar. Aus dem ersten Ausgangsstoff werden Radikale erzeugt. Dies kann in der in der Literatur beschriebenen Weise erfolgen, beispielsweise durch ein Plasma, einen Heißdraht oder eine Hochfrequenzaktivierung. Bevorzugt werden die Radikale aber dadurch erzeugt, dass das erste Prozessgas beim Eintritt in das Gaseinlassorgan bzw. in die Prozesskammer von einem hohen Druck, der oberhalb des Atmosphärendrucks liegt, zu einem niedrigen Druck entspannt wird, wobei der niedrige Druck dem Totaldruck in der Prozesskammer entspricht, der weniger als 300 mbar beträgt. Beispielsweise können $Ge_2H_6$ oder $Si_2H_6$ in German- oder Silanradikale ($GeH_3^*$ oder $SiH_3^*$) zerfallen. Wegen des geringen Partialdrucks in der Prozesskammer reduziert sich die Rückreaktionsrate, so dass das in die Prozesskammer eingespeiste Trägergas Radikale zur Oberfläche eines auf eine Substrattemperatur aufgeheizten Halbleitersubstrats transportiert. Da kein $H_2$ oder nur ein Minimum an $H_2$ in der Gasphase vorhanden ist, fehlt der erforderliche Reaktionsparameter, um $GeH_4$ bzw. $SiH_4$ zu bilden. Es entstehen somit hochverdünnte Radikale in der Gasphase. Die Substrattemperatur ist niedriger als die Zerlegungstemperatur des reinen Radikals. Dies hat zur Folge, dass ohne die Beimischung des Chlorides nur ein verschwindend geringes Wachstum von 1 nm/h und weniger stattfinden würde. Erfindungsgemäß wird aber zusammen mit den Radikalen das Chlorid zur Substratoberfläche transportiert. Dort findet eine erste Reaktion zwischen den Radikalen und den Chloriden statt. Bei dieser exothermen Reaktion wird Reaktionswärme frei, die zu einer lokalen Temperaturerhöhung an der Oberfläche der Schicht bzw. des Substrates führt. Dort wo die erste Reaktion stattfindet, besitzt die Oberfläche somit eine Temperatur, die zur Zerlegung des ersten Ausgangsstoffes und insbesondere des daraus dissoziierten Radikals ausreicht. In der ersten Reaktion entsteht ein gasförmiges Reaktionsprodukt, das mit dem Trägergas abgeführt wird. Als nichtgasförmiges Reaktionsprodukt verbleiben die ersten und zweiten Elemente an der Oberfläche. Bei der zweiten Reaktion, die durch die Reaktionswärme der ersten Reaktion in Gang gesetzt wird, zerfällt das Radikal in ein flüchtiges Reaktionsprodukt, das mit dem Trägergas abtransportiert wird, und in das erste Element. Als Folge der beiden zeitgleich stattfindenden Reaktionen sind Atome des ersten Elementes und zweiten Elementes an der Substratoberfläche adsorbiert. Das Substrat liegt auf einem von unten, beispielsweise durch eine Lampenheizung beheizten Suszeptor auf. Dieser ist etwa 1 bis 2 cm von der Gasaustrittsfläche des Showerheads beabstandet. Die Substrattemperatur liegt unterhalb des zuvor genannten oberen Grenzwertes, so dass das reine Hydrid oder das reine Radikal an der Oberfläche nicht zerfallen kann, sondern nur durch die zuvor genannte Kettenreaktion in seine Bestandteile zerlegt wird. Die Substrattemperatur ist ausreichend hoch (sie liegt bevorzugt im Bereich zwischen 300° C und 450° C) um eine Oberflächenbeweglichkeit der aus den beiden chemischen Reaktionen hervorgegangenen nichtflüchtigen Reaktionsprodukte zu gewährleisten. Einen signifikanten Beitrag zur Steigerung der Oberflächenmobilität liefert die Reaktionswärme der ersten Reaktion zwischen den Radikalen und den Halogeniden. Die an der Oberfläche adsorbierten Atome der ein oder mehreren Elemente können sich somit für eine kurze Zeit und Strecke geringfügig über die Oberfläche bewegen, um energetisch günstige Einbauplätze in das Kristallgitter zu finden. Die lokale Oberflächentemperatur ist derart hoch, dass die Atome des ersten Elementes und des zweiten Elementes in kristalliner Ordnung in der Oberfläche eingebaut werden. Da die Oberfläche der Schicht wärmer ist als das Substrat, die Oberfläche also eine höhere Temperatur aufweist als die Substrattemperatur, wird eine ansonsten bei der Substrattemperatur auftretende Oberflächenrauhigkeit unterdrückt. Eine Amorphisierung findet nicht statt. Bei den Experimenten, über die in der eingangs zitierten Literatur berichtet wird, wurden dünne SiGeSn-Schichten auf Ge-Schichten abgeschieden. Unter den dortigen Prozessbedingungen wurden relativ dünne (45 nm bzw. 85 nm dicke) Schichten auf Silizium-Substraten bzw. Germanium-Pseudo-Substraten abgeschieden. Aufgrund des relativ großen Unterschiedes der Kristallgitterkonstante eines GeSn-Kristalls zu einem Ge-Kristall tritt bei der Abscheidung eine tetragonale Verzerrung des Kristalls des aufgewachsenen Materials auf. Die planare Gitterkonstante senkrecht zur Wachstumsrichtung passt sich der kubischen Gitterkonstante des Substrates an. Die senkrechte Gitterkonstante, die sich parallel zur Wachstumsrichtung erstreckt, vergrößert sich. Bei den eingangs genannten Voruntersuchungen wurde eine mit zunehmender Schichtdicke rauere Oberfläche beobachtet. Es wurde die Bildung von Gitterfehlanpassungsversetzungen an der Grenzfläche zum dort verwendeten Si-Substrat beobachtet sowie eine hohe Dichte von Fadenversetzungen, die sich durch die komplette 85 nm-Schicht bis zur Oberfläche ziehen. Bei den verwendeten niedrigen Wachstumstemperaturen für das GeSn-Wachstum ist die Oberflächenmobilität der auf der Oberfläche adsorbierten Moleküle der gasförmigen Ausgangsstoffe bzw. deren Zerlegungsprodukte stark reduziert, was zu einer großen Rauigkeit und letztendlich zu der beobachteten Amorphisierung führt. Überraschenderweise hat sich herausgestellt, dass mit Hilfe der erfindungsgemäßen Radikal-unterstützten Wachstumsmethode der ansonsten erwartete "epitaxial breakdown" insbesondere bei der Verwendung einer Ge-Bufferschicht nicht eintritt. Bei Schichtdicken oberhalb einer kritischen Schichtdicke beginnt eine Relaxation der Schicht, die bis zu 80 % oder mehr anwachsen kann und bevorzugt über 80 % anwächst. Die Dichte von Fadenversetzungen reduziert sich auf Werte von kleiner $10^6$ cm$^{-2}$ bzw. kleiner $10^5$ cm$^{-2}$. Die Gitterfehlanpassungsversetzungen sind auf einen kleinen Bereich (10 nm bis 20 nm) nahe der Grenzfläche lokalisiert. Die ansonsten erwarteten Fadenversetzungen oder Schraubenversetzungen konnten nicht festgestellt werden. Signifikante Gitterfehlanpassungsversetzungen wurden nur in dem Bereich bis zu 10 nm bis 20 nm angrenzend an die Grenzfläche beobachtet, wobei auch Versetzungen in der Ge-Bufferschicht unmittelbar angrenzend an die Grenzschicht beobachtet wurden. Der Relaxionsmechanismus wurde insbesondere bei Schichten, die mindestens eine Schichtdicke von 200 nm aufweisen beobachtet, die auf eine defektarme Ge-Bufferschicht abgeschieden wurden, wobei die Ge-Bufferschicht auf ein Si(001)-Substrat abgeschieden worden ist. Sowohl das Abscheiden der Bufferschicht als auch das Abscheiden der IV-IV-Schicht kann in einem Gesamtprozess in aufeinanderfolgenden Prozessschritten in einer Prozesskammer eines CVD-Reaktors ohne zwischenzeitiges Öffnen der Prozesskammer stattfinden. Wesentlich ist ein Schichtwachstum von mindestens 200 nm, bevorzugt von mind. 300 nm. Das erfindungsgemäße Verfahren benutzt zur lokalen Erwärmung der Schichtoberfläche die Reaktionswärme einer reaktiven Gasquelle (Radikale). Es findet ein Kristallwachstum im Nichtgleichgewichtszustand statt. Der Nichtgleichgewichtszustand wird gewissermaßen eingefroren, da als Folge eines hohen Temperaturgradienten die durch die chemische Reaktion erzeugte lokale Wärme in kurzer Zeit in dem Kristall abgeführt wird. Als erster gasförmiger Ausgangsstoff kann eines der oben genannten Hydride der V-Haupt-gruppe verwendet werden. Als zweiter gasförmiger Ausgangsstoff wird bevorzugt eines der oben genannten Halogenide der III-Hauptgruppe verwendet. Es ist auch vorgesehen, Hydride der Elemente der VI-Hauptgruppe und Halogenide, insbesondere Chloride von Elementen der II-Hauptgruppe zu verwenden. Besonders bevorzugt wird das Verfahren aber verwendet, um IV-IV Schichten auf IV-IV-Substraten abzuscheiden. Bevorzugt beinhalten die beiden gasförmigen Ausgangsstoffe zwei voneinander verschiedene Elemente, beispielsweise Ge und Sn. Als erster gasförmiger Ausgangsstoff wird dann $Si_2H_6$, gegebenenfalls auch $SiH_4$ oder $Ge_2H_6$, gegebenenfalls auch $GeH_4$ verwendet. Als zweiter Ausgangsstoff wird ein Halogenid eines Elementes der IV-Hauptgruppe verwendet, beispielsweise ein Bromid, ein Jodid oder ein Chlorid. Bevorzugt wird $SnCl_4$ verwendet. $SnCl_4$ und $Ge_2H_6$ bzw. $Si_2H_6$ werden durch ein gekühltes Gaseinlassorgan in eine Prozesskammer eingeleitet. Der Totaldruck in der Prozesskammer hat einen Wert, bei dem $Ge_2H_6$, bevorzugt aber auch $Si_2H_6$ überwiegend in Radikale zerfallen ist. Diese Radikale werden zusammen mit dem Chlorid mittels eines inerten Trägergases, insbesondere $N_2$, bevorzugt kein $H_2$, zur Substratoberfläche transportiert. Die Moleküle adsorbieren an der Oberfläche. Es findet eine exotherme Oberflächenreaktion zwischen dem Radikal und dem Chlorid statt, bei der HCl und Energie frei wird. Die Energie aktiviert weitere Zerfälle des Radikals und eine lokale Erwärmung der Oberfläche, so dass die Ge-Atome und Sn-Atome eine ausreichende Oberflächenmobilität besitzen, um einkristallin in das Kristall eingebaut zu werden. Es wurde beobachtet, dass bereits bei einem Sn-Anteil von mehr als 8 % photolumineszierende Schichten entstehen, wenn die Voraussetzung zur Bildung von Radikalen vorliegen und eine Schichtdicke oberhalb einer kritischen Dicke abgeschieden wird. Die Veränderung des Bandübergangs weg von einem indirekten Bandübergang hin zu einem direkten Bandübergang tritt bei einem Sn-Anteil in Ge bzw. SiGe abhängig von der Verspannung bei mehr als 8 %, insbesondere bei mehr als 10 % auf. Der maximal erforderliche Sn-Anteil für unverspanntes GeSn liegt bei 14 % bzw. bei 20 %. Das Hydrid, insbesondere das $Ge_2H_6$ besitzt in der Prozesskammer einen Partialdruck im Bereich zwischen 60 Pa und 120 Pa. Das Halogenid, insbesondere das $SnCl_4$ wird mit einem derartigen Fluss in die Prozesskammer eingespeist, dass der Partialdruck etwa zwischen 0,1 % und 5 % des Partialdrucks des Hydrides liegt, insbesondere im Bereich zwischen 0,03 Pa und 1,25 Pa. Das Abscheiden der optisch aktiven Schicht erfolgt bevorzugt auf einer relaxierten Ge-Bufferschicht. Bei Wachstumsraten zwischen 10 nm/min und 50 nm/min. Ein erster gasförmiger Ausgangsstoff ist somit ein Siliziumwasserstoff oder ein Germaniumwasserstoff.

Die Erfindung betrifft darüber hinaus ein Bauelement mit einer Schichtstruktur, die eine mit dem oben genannten Verfahren abgeschiedene Schicht, insbesondere GeSn- oder SiGeSn-Schicht aufweist. Der Sn-Anteil liegt in einem Bereich von 10 % bis 14 %. Die Schichtdicke ist größer als 200 nm, bevorzugt größer als 300 nm. Die Versetzungsdichte innerhalb des Schichtvolumens, also außerhalb eines 10 nm bis 20 nm an die Grenzfläche zur Bufferschicht angrenzenden Bereiches, bei kleiner $10^6$ cm$^{-2}$ bzw. $10^{-5}$ cm$^{-2}$. Lediglich in dem unmittelbar an die Bufferschicht angrenzenden Bereich besitzt die Schicht eine höhere Versetzungsdichte. Im Bereich 10 nm bis 20 nm nahe der Grenzfläche befinden sich insbesondere stufenförmige Versetzungen, jedoch nur in geringem Umfang schraubenförmige oder fadenförmige Versetzungen. Die Schicht besitzt einen direkten Bandübergang mit einer Energie von etwa 450 meV und ist in der Lage, nach optischer oder elektrischer Anregung zu photolumineszieren.

Die Erfindung betrifft darüber hinaus einen integrierten Schaltkreis, insbesondere MOS-Schaltkreise, mit einer monolithisch aufgebauten integrierten Schaltung, wobei als Substrat insbesondere ein Si-Substrat verwendet wird. Erfindungsgemäß ist auf das Substrat oder auf eine auf das Substrat aufgebrachte Bufferschicht eine GeSn- oder GeSn enthaltende Schichtenfolge aufgebracht, wobei insbesondere vorgesehen ist, dass die Schichtenfolge eine GeSn-Schicht aufweist, die zwischen zwei SiGeSn-Schichten angeordnet ist. Ein derartiger integrierter Schaltkreis besitzt eine Vielzahl von bekannten Bauelementen, beispielsweise Transistoren, Kondensatoren sowie elektrisch leitenden Schichten und elektrisch isolierenden Schichten. Erfindungsgemäß ist der integrierte Schaltkreis um optisch aktive Bauelemente ergänzt worden, die monolithisch auf demselben Substrat abgeschieden werden, so dass in einem derartigen integrierten Schaltkreis nicht nur Strom, sondern auch Licht zur Informationsverbreitung verwendet werden kann.

Details der Erfindung werden nachfolgend anhand beigefügter Zeichnungen erläutert. Es zeigen:

Fig.1      den Querschnitt durch einen CVD-Reaktor, wie er zum Abscheiden der Schichten verwendet werden kann;
Fig. 2a    die elektrische Bandstruktur eines nicht erfindungsgemäßen GeSn-Halbleiters mit einem Sn-Anteil von 8 %;
Fig. 2b    die elektrische Bandstruktur eines GeSn-Halbleiters mit einem Sn-Anteil von 13 %;
Fig. 3a    das Photolumineszenzspektrum einer nicht erfindungsgemäßen GeSn-Halbleiterschicht mit einem Sn-Anteil von 8 %;
Fig. 3b    das Photolumineszenzspektrum einer nicht erfindungsgemäßen GeSn-Halbleiterschicht mit einem Sn-Anteil von 9, 6 %;
Fig. 3c    das Photolumineszenzspektrum einer GeSn-Halbleiterschicht mit einem Sn-Anteil von 11,1 %;
Fig. 3d    das Photolumineszenzspektrum einer GeSn-Halbleiterschicht mit einem Sn-Anteil von 12,6 %;
Fig. 4     das Beispiel einer erfindungsgemäßen Schichtenfolge;

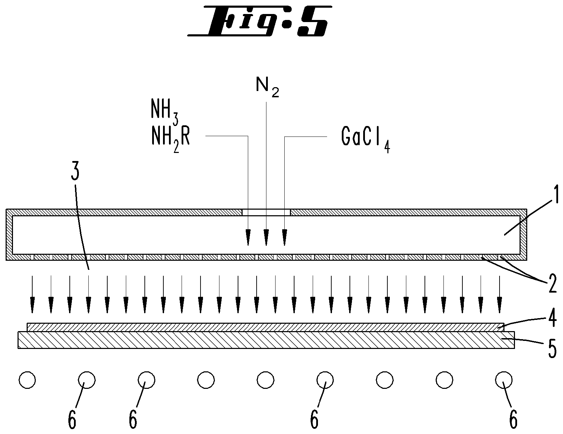

Fig. 5     eine Darstellung gemäß Figur 1 betreffend die nicht erfindungsgemäße Abscheidung von GaN.

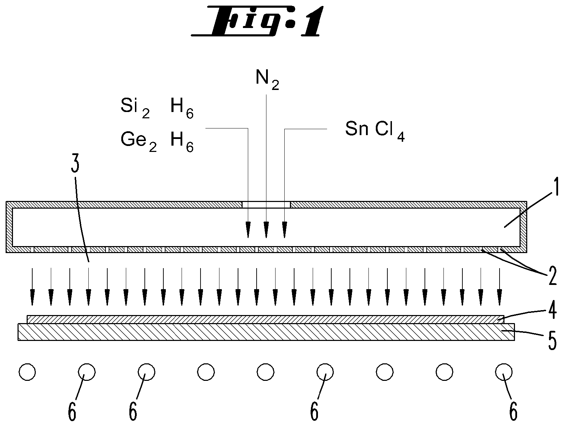

Die Figur 1 zeigt grob schematisch den Querschnitt durch einen CVD-Reaktor, wie er zur Durchführung des Verfahrens bzw. zum Abscheiden der Schichten der erfindungsgemäßen Bauelemente verwendet wird. Nicht dargestellt ist eine externe Gasversorgung zur Bereitstellung der Prozessgase, nämlich $Si_2H_6$ und $Ge_2H_6$ sowie $SnCl_4$ und als Inertgas $N_2$. Der Reaktor besitzt ein gasdicht nach außen verschlossenes Gehäuse, dessen Inneres mittels einer Vakuumeinrichtung evakuierbar bzw. auf einen Totaldruck im Bereich von 0 mbar bis 1.000 mbar regelbar ist. Innerhalb des Reaktorgehäuses befindet sich ein Gaseinlassorgan 1 in Form eines Showerheads. Es handelt sich dabei um eine Gasverteilkammer, die mit den Prozessgasen und dem Inertgas gespeist wird. Die Figur 1 zeigt ein Gaseinlassorgan 1 mit lediglich einem Gasverteilvolumen. Es ist aber auch vorgesehen, dass die drei Prozessgase getrennt voneinander durch jeweils eine Gasverteilkammer in eine unterhalb des Gaseinlassorgans 1 angeordnete Prozesskammer 3 eingeleitet werden. Dies erfolgt durch Gasaustrittsöffnungen 2 einer Gasaustrittsfläche des Gaseinlassorgans 1.

Der Boden der Prozesskammer 3 wird von einem Graphit-Suszeptor 5 ausgebildet, der etwa 1 cm bis 2 cm von der Gasaustrittsfläche entfernt ist. Auf dem Suszeptor 5 befinden sich ein oder mehrere Si-Substrate 4.

Unterhalb des Suszeptors 5 befindet sich eine Heizung 6, beispielsweise eine Lampenheizung, um den Suszeptor 5 auf eine Prozesstemperatur von beispielsweise 300° C bis 400° C aufzuheizen.

Es werden beispielshaft vier Experimente erläutert.

Die Wachstumsparameter der vier Schichten A, B, C, D sind der nachfolgend eingeblendeten Tabelle zu entnehmen.

| | x_Sn (at. %) | Gesamtfluss (sccm) | Reaktordruck (mbar) | Temperatur (°C) | $Ge_2H_6$-Fluss (sccm) | $SnCl_4$-Fluss (sccm) | $SnCl_4$ bubbler Temperatur (°C) | Wachstumszeit (min) | Dampfdruck $SnCl_4$ (mbar) |
|---|---|---|---|---|---|---|---|---|---|
| A | 8 | 2000 | 60 | 390 | 400 | 25 | 20 | 3.75 | 25 |
| B | 9.6 | 2000 | 60 | 375 | 400 | 25 | 20 | 4.83 | 25 |
| | 11.1 | 2000 | 60 | 375 | 400 | 25 | 20 | 6 | 25 |
| D | 12.6 | 2000 | 60 | 350 | 400 | 12 | 20 | 13.33 | 25 |

Als Trägergas wurde $N_2$ verwendet. Die $SnCl_4$ bubbler wurden allerdings mit $H_2$ als Trägergas betrieben, um gasförmiges $SnCl_4$ in den Reaktor zu leiten. Die Schichten A und C wurden scheinbar mit denselben Wachstumsparametern gefertigt. Zu berücksichtigen ist hier allerdings, dass aufgrund einer Drift in der CVD-Anlage, insbesondere in der $SnCl_4$-Quelle die tatsächlichen $SnCl_4$-Flüsse verschieden gewesen sind. Das Verdünnungsverhältnis von $SnCl_4$ im $H_2$-Trägergasfluss durch den bubbler liegt bei etwa 10 % und unterliegt einer Drift, die insbesondere vom Füllungsstand des flüssigen Ausgangsstoffes im Quellenbehälter abhängt.

Auf einem Si(001)-Substrat wurde zunächst eine Ge-Bufferschicht abgeschieden. Die Ge-Bufferschicht besitzt eine hochqualitative Oberfläche. Es handelt sich um eine defektarme Ge-Bufferschicht mit einer Oberflächenrauigkeit im Bereich von 0.25 nm. Das Abscheiden der Ge-Bufferschicht erfolgte durch Einleiten von $Ge_2H_6$ in die Prozesskammer.

Auf die Ge-Bufferschicht wurden bei einem $Ge_2H_6$-Fluss von 400 sccm und einem Gesamtfluss von 2.000 sccm bei einem Totaldruck von 60 mbar in vier verschiedenen Experimenten Schichten aus $Ge_{1-x}Sn_x$ abgeschieden, wobei der Sn-Anteil 8 %, 9,6 %, 11,1 % bzw. 12, 6% betrug. Das Abscheiden erfolgte bei verschiedenen Temperaturen, wobei die Wachstumstemperatur einen Einfluss auf den Sn-Einbau besitzt. Die Wachstumsraten variieren zwischen 17 nm/min und 49 nm/min. Es wurden Schichten in einer Dicke von etwa 200 nm abgeschieden.

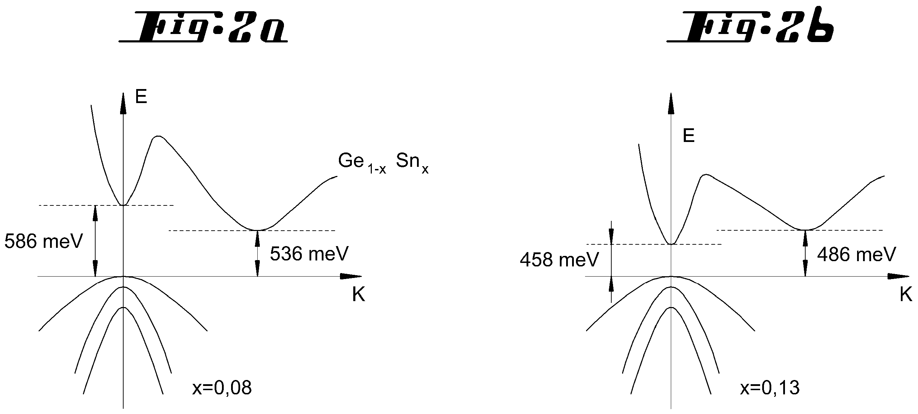

Die Figuren 2a und 2b zeigen die Bandstruktur eines $Ge_{1-x}Sn_x$-Kristalls, wobei die Figur 2a die Bandstruktur eines Kristalls mit einem Sn-Anteil von 8 % und die Figur 2b die Bandstruktur mit einem Sn-Anteil von 13 % zeigt. Die Figur 2a zeigt, dass die direkte Bandlücke (Γ-Valley) eine größere Energie besitzt als die indirekte Bandlücke (L-Valley). Mit zunehmender Steigerung des Sn-Anteils verschieben sich sowohl die indirekte Bandlücke (L-Valley) als auch die direkte Bandlücke (Γ-Valley) zu niedrigeren Energien, wobei die Energie der Bandlücke des direkten Bandübergangs stärker absinkt, so dass in einem Bereich zwischen 8 % Sn-Anteil und 13 % Sn-Anteil der Bandübergang vom indirekten zum direkten wechselt. Da die Bandstruktur nicht nur vom Sn-Anteil, sondern auch von den Gitterverspannungen abhängt, lässt sich ein kritischer Sn-Anteil nicht angeben.

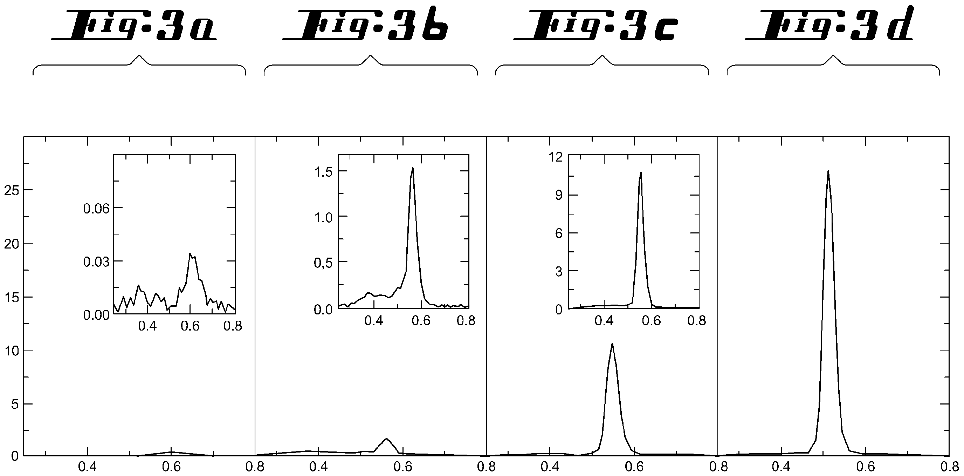

Die Figuren 3a bis 3d zeigen die Photolumineszenzspektren von Schichten mit voneinander verschiedenen Sn-Anteilen. Es ist erkennbar, dass die Schicht A mit einem Sn-Anteil von 8 % nur eine geringe Photolumineszenz, die Schicht B mit einem Sn-Anteil von 9, 6 % bereits eine erkennbare Photolumineszenz, die Schicht C mit einem Sn-Anteil von 11, 1 % eine deutliche Photolumineszenz und die Schicht D mit einem Sn-Anteil von 12,6 % eine starke Photolumineszenz jeweils bei 20° K zeigen.

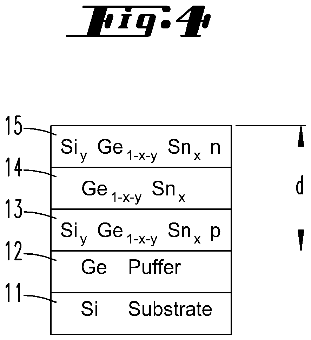

Die Figur 4 zeigt das Beispiel einer lichtemittierenden Schichtstruktur bestehend aus einer Schichtenfolge 13, 14, 15 mit einer Schichtdicke von mindestens 200 nm. Aus der in Figur 4 dargestellten Schichtenfolge kann beispielsweise ein Laser-Bauelement hergestellt werden, welches monolithisch in einen Schaltkreis integrierbar ist, der monolithisch auf ein Silizium-Substrat 11 aufgebracht worden ist. Auf ein Silizium-Substrat 11 wird zunächst eine Ge-Bufferschicht 12 abgeschieden. Auf die Ge-Bufferschicht 12 dann die erste Schicht SiGeSn 13 der Schichtenfolge, die p-dotiert ist, abgeschieden. Darauf wird eine aktive GeSn-Schicht 14 abgeschieden. Schließlich wird auf die aktive Schicht 14 eine n-dotierte SiGeSn-Schicht 15 abgeschieden. Der Sn-Anteil (x-Wert) liegt im Bereich zwischen 0,1 und 0,14. Der Si-Anteil (y-Wert) liegt im Bereich zwischen 0 und 0,2.

Bei dem Verfahren werden $Ge_2H_6$ aus einem Vorratsbehälter bei einem Druck über 1.000 mbar zusammen mit $N_2$ in das Gaseinlassorgan 1 eingespeist. $Ge_2H_6$ und $Ge H_3^*$ liegen gemäß folgender Gleichgewichtsreaktion im thermodynamischen Gleichgewicht.

$$Ge_2H_6 \rightarrow 2GeH_3^*$$

Während im Vorratsbehälter die linke Seite der Gleichgewichtsreaktion dominiert, wird das Verfahren so geführt, dass in der Prozesskammer die rechte Seite der Gleichgewichtsreaktion dominiert. Die Zerlegung von $G_2H_6$ in $GeH_3^*$ erfolgt aufgrund einer pneumatischen Expansion des Gases von einem Druck oberhalb Atmosphärendruck zu einem Sub-Atmosphärendruck. Im Ausführungsbeispiel erfolgt die Expansion nach 60 mbar.

Des Weiteren wird $SnCl_4$ in die Prozesskammer eingeleitet. Mit $N_2$ als Trägergas wird $SnCl_4$ und $GeH_3^*$ zur Oberfläche des Substrates 4 gefördert, welches auf dem beheizten Suszeptor 5 liegt und eine Oberflächentemperatur zwischen 350° C und 390° C besitzt. $SnCl_4$ und $GeH_3^*$ adsorbieren an der Oberfläche und reagieren dort exotherm miteinander.

$$4GeH_3^* + 3SnCl_4 \rightarrow 4Ge + 3Sn + 12HCl + Energie$$

Das bei dieser Reaktion entstehende HCl wird vom Trägergas aus der Prozesskammer 3 gefördert. Die freiwerdende Energie führt zu einer lokalen Erwärmung der Oberfläche. Die Ge- und Sn-Atome bleiben an der Oberfläche adsorbiert.

Zufolge der lokalen Erhöhung der Temperatur der Oberfläche kann die folgende endotherme Zerlegungsreaktion stattfinden.

2GeH3* + Energie → 2Ge + 3H$_2$

Parallel kann auch die folgende Zerlegungsreaktion von undissoziiertem Ge$_2$H$_6$ stattfinden.

Ge$_2$H$_6$ + Energie → 2Ge + 3H$_2$

Der dabei entstehende Wasserstoff wird vom Trägergas abtransportiert. Die Oberfläche wird lokal auf eine derartige Temperatur aufgeheizt, dass die Ge- und Sn-Atome eine ausreichende Oberflächenmobilität besitzen, um einkristallin einen Kristall aufzubauen. Bei der Prozesstemperatur (350° C bis 390° C) besitzt der so abgeschiedene Kristall eine Kristallstruktur, die weit jenseits des thermodynamischen Gleichgewichtes liegt (anstelle eines Sn-Anteils von maximal 1 % kann der Sn-Anteil bis zu 20 % betragen).

Wird zusätzlich noch eine Si-Komponente mit in die Prozesskammer eingebracht, so erfolgt dies unter Verwendung von Si$_2$H$_6$ als Ausgangsstoff, der analog des zuvor beschriebenen Mechanismus in adsorbierte Si-Atome zerlegt wird.

Es werden Schichten mit folgender Zusammensetzung abgeschieden

Si$_y$Ge$_{1-x-y}$Sn$_x$

$$0{,}10 \leq x \leq 0{,}14$$

$$0 \leq y \leq 0{,}2$$

Die Schicht 14 oder Schichtenfolge 13, 14, 15 soll erfindungsgemäß eine Mindestschichtdicke d von mindestens 200 nm, bevorzugt mindestens 300 nm besitzen. Bei einer derartigen Schichtdicke, die mit Wachstumsraten von 15 nm/min bis 50 nm/min abgeschieden worden ist, liegt die Versetzungsdichte im Schichtvolumen, also oberhalb eines Grenzbereiches zur Bufferschicht 12 von einer Dicke von 10 nm bis 20 nm bei maximal 10$^5$ cm$^{-2}$ bis 10$^6$cm$^{-2}$. Im Grenzbereich, also in den ersten 10 nm bis 20 nm der Schicht bzw. Schichtenfolge kann die Versetzungsdichte durchaus höhere Werte annehmen. Schraubenförmige oder fadenförmige Versetzungen besitzen dort jedoch eine Maximaldichte von 5 x 10$^6$ cm$^{-2}$.

Erfindungsgemäß erreichen die in der Gasphasenreaktion entstandenen Radikale die Oberfläche und reagieren erst dort miteinander.

Bezugszeichenliste

| 1 | Gasseinlassorgan |
|---|---|
| 2 | Gasaustrittsöffnung |
| 3 | Prozesskammer |
| 4 | Substrat |
| 5 | Suszeptor |
| 6 | Heizung |
| 11 | Silizium-Substrat |
| 12 | Ge-Bufferschicht |
| 13 | Schichtenfolge |
| 14 | Schichtenfolge |
| 15 | Schichtenfolge |
| | |
| d | Schichtdicke |

**Patentansprüche**

1. Verfahren zum Abscheiden eines optoelektronischen Bauelements mit einer einkristallinen, Si$_y$Ge$_{1-x-y}$Sn$_x$ Halbleiterschicht,

wobei Si und Ge als Bestandteil eines ersten gasförmigen Ausgangsstoffs in Form eines Hydrids, und Sn als Bestandteil eines zweiten gasförmigen Ausgangsstoffs in Form des Halogenids, $SnCl_4$ zusammen mit einem von einem Inertgas gebildeten Trägergas, in eine Prozesskammer (3) eines CVD-Reaktors eingespeist werden,

wobei aus dem ersten Ausgangsstoff in einer Gasphasenreaktion Radikale, die in reiner Form eine Zerlegungstemperatur besitzen, erzeugt werden,

die Radikale und der zweite Ausgangsstoff zusammen zur Oberfläche eines auf eine Substrattemperatur aufgeheizten Halbleitersubstrat gebracht werden, welche niedriger ist als die Zerlegungstemperatur des reinen Radikals,

wobei die Radikale in einer ersten Reaktion exotherm mit dem $SnCl_4$ an der Oberfläche reagieren, wobei als Reaktionsprodukte Si-, Ge-, und Sn Atome an der Oberfläche bleiben,

und sich die Radikale in einer zweiten Reaktion gleichzeitig zur ersten Reaktion sich durch Aufnahme der bei der ersten Reaktion frei gewordenen Wärme endotherm zerlegen,

wobei die in der Gasphasenreaktion entstandenen Radikale erst an der Oberfläche in der ersten Reaktion mit dem Halogenid reagieren,

so dass die bei der exothermen Reaktion frei werdende Reaktionswärme die zweite Reaktion in Gang setzt und zu einer lokalen Temperaturerhöhung an der Oberfläche der Schicht oder des Substrates führt,

bei der die Si-, Ge- und Sn-Atome in kristalliner Ordnung in der Oberfläche eingebaut werden,

und dadurch charakterisiert, dass eine photolumineszierende Schicht entsteht, die einen Sn-Anteil x zwischen 0,1 und 0,14 und einem Si-Anteil y zwischen 0 und 0,2 aufweist.

2. Verfahren nach Anspruch 1, **dadurch gekennzeichnet, dass** die Radikale durch pneumatisches Entspannen des ersten gasförmigen Ausgangsstoffs beim Einspeisen in die Prozesskammer von einem Druck größer als 1.000 mbar in einen Prozesskammerdruck von weniger als 300 mbar erzeugt werden.

3. Verfahren nach einem der Ansprüche 1 oder 2, **dadurch gekennzeichnet, dass** das Hydrid mit einem Partialdruck von 60 Pa bis 120 Pa in die Prozesskammer eingespeist wird.

4. Verfahren nach einem der Ansprüche 1 bis 3, **dadurch gekennzeichnet, dass** das Halogenid mit einem Partialdruck von 0,1 % bis 5 % des Partialdrucks des Hydrids, insbesondere mit einem Partialdruck von 0,03 Pa bis 1,25 Pa in die Prozesskammer eingespeist wird.

5. Verfahren nach einem der Ansprüche 1 bis 4, **dadurch gekennzeichnet, dass** die Schicht oder die Schichtenfolge auf eine auf einem Si-Substrat aufgebrachte Ge-Bufferschicht abgeschieden wird.

6. Verfahren nach einem der Ansprüche 1 bis 5, **dadurch gekennzeichnet, dass** die Substrattemperatur in einem Bereich zwischen 350° C und 390° C liegt.

7. Verfahren nach einem der Ansprüche 1 bis 6, **dadurch gekennzeichnet, dass** das Abscheiden der Schicht oder Schichtenfolge mit einer Wachstumsrate im Bereich zwischen 15 nm/min und 50 nm/ min erfolgt.

8. Nach dem Verfahren nach einem der vorhergehenden Ansprüchen hergestelltes optoelektronisches Bauelement, beispielsweise Laser, Fotodiode, Fotosensor, Fotoelement, Lichtleiter oder dergleichen mit einer auf einer Ge-Bufferschicht eines Si-Substrats epitaktisch abgeschiedenen, einkristallinen, bei Anregung leuchtenden, $Si_yGe_{1-x-y}Sn_x$ Halbleiterschicht mit einer Versetzungsdichte innerhalb des Schichtvolumens, dass heisst außerhalb eines 10 nm bis 20 nm an die Grenzfläche zur Bufferschicht angrenzenden Bereiches, von kleiner $10^6$ cm$^{-2}$,

9. Verfahren nach einem der Ansprüche1 bis 7 oder optoelektronisches Bauelement nach Anspruch 8, **dadurch gekennzeichnet, dass** die Schicht einen Relaxationsgrad von größer 80 % besitzt und/oder die Versetzungsdichte kleiner als $10^5$ cm$^2$ ist und/oder dass sich die Gitterfehlstellen auf einen Bereich nahe der Grenzschicht zur Bufferschicht, insbesondere auf einen Bereich von 10 nm bis 20 nm angrenzend an die Grenzschicht, beschränken.

10. Verfahren nach einem der Ansprüche 1-7 oder 9 oder optoelektronisches Bauelement nach einem der Ansprüche 8 oder 9, **dadurch gekennzeichnet, dass** die Schichtenfolge eine GeSn-Schicht ist, die zwischen zwei SiGeSn-Schichten angeordnet ist.

11. Auf einem Substrat aufgebrachte integrierte Schaltung, insbesondere Mikroprozessor, **gekennzeichnet durch** ein auf eine im monolithischen Verbund mit dem Substrat stehende Bufferschicht aufgebrachtes optoelektronisches Bauelement gemäß einem der Ansprüche 9 bis 10.

**Claims**

1. A method for depositing an optoelectronic component having a monocrystalline, $Si_yGe_{i.x.y}Sn_x$ semiconductor layer,

   wherein Si and Ge as a component of a first gaseous starting material in the form of a hydride,
   and Sn as a component of a second gaseous starting material in the form of the halide, $SnCl_4$, together with a carrier gas formed by an inert gas, are fed into a process chamber (3) of a CVD reactor,
   wherein radicals, which in pure form have a decomposition temperature, are produced from the first starting material in a gas phase reaction,
   the radicals and the second starting material are brought together to the surface of a semiconductor substrate heated to a substrate temperature which is lower than the decomposition temperature of the pure radical,
   wherein the radicals in a first reaction react exothermically with the $SnCl_4$ on the surface, wherein Si, Ge and Sn atoms remain on the surface as reaction products,
   and the radicals decompose endothermically in a second reaction at the same time as the first reaction by absorbing the heat released during the first reaction,
   wherein
   the radicals formed in the gas phase reaction only react with the halide on the surface in the first reaction, so that the heat of reaction released in the exothermic reaction sets the second reaction in motion and leads to a local temperature increase on the surface of the layer or the substrate,
   in which the Si, Ge and Sn atoms are built into the surface in a crystalline order,
   and **characterised in that**
   a photoluminescent layer having an Sn component x between 0.1 and 0.14 and an Si component y between 0 and 0.2 is produced.

2. The method according to claim 1, **characterised in that** the radicals are produced by pneumatic expansion of the first gaseous starting material when feeding into the process chamber from a pressure greater than 1,000 mbar to a process chamber pressure of less than 300 mbar.

3. The method according to any one of claims 1 or 2, **characterised in that** the hydride is fed with a partial pressure of 60 Pa to 120 Pa into the process chamber.

4. The method according to any one of claims 1 to 3, **characterised in that** the halide is fed into the process chamber with a partial pressure of 0.1% to 5% of the partial pressure of the hydride, in particular with a partial pressure of 0.03 Pa to 1.25 Pa.

5. The method according to any one of claims 1 to 4, **characterised in that** the layer or the layer sequence is deposited on a Ge buffer layer applied to an Si substrate.

6. The method according to any one of claims 1 to 5, **characterised in that** the substrate temperature lies in a range between 350°C and 390°C.

7. The method according to any one of claims 1 to 6, **characterised in that** the layer or layer sequence is deposited at a growth rate in the range between 15 nm/min and 50 nm/min.

8. An optoelectronic component produced by the method according to any one of the preceding claims, for example, laser, photodiode, photosensor, photo element, light guide or the like having a monocrystalline $Si_yGe_{1.x.y}Sn_x$ semiconductor layer that has been epitaxially deposited on a Ge buffer layer of a Si substrate and glows when excited, and has a dislocation density within the layer volume, that is, outside a 10 nm to 20 nm region adjoining the interface to the buffer layer, of less than $10^6$ cm$^{-2}$.

9. The method according to any one of claims 1 to 7 or the optoelectronic component according to claim 8, **characterised in that** the layer has a relaxation degree of greater than 80% and/or the dislocation density is less than $10^5$ cm$^2$ and/or that the lattice defects are limited to a region close to the boundary layer to the buffer layer, in particular to a region of 10 nm to 20 nm adjacent to the boundary layer.

**10.** The method according to any one of claims 1-7 or 9 or the optoelectronic component according to any one of claims 8 or 9, **characterised in that** the layer sequence is a GeSn layer which is arranged between two SiGeSn layers.

**11.** An integrated circuit applied to a substrate, in particular a microprocessor, **characterised by** an optoelectronic component according to any one of claims 9 to 10 applied to a buffer layer in a monolithic bond with the substrate.

**Revendications**

**1.** Procédé de dépôt d'un composant optoélectronique comprenant une couche semiconductrice monocristalline de $Si_yGe_{1-x-y}Sn_x$,

dans lequel Si et Ge en tant que composants d'une substance gazeuse de départ sous forme d'un hydrure et Sn en tant que composant d'une deuxième substance gazeuse de départ sous forme de l'halogénure $SnCl_4$ sont introduits dans une chambre de traitement (3) d'un réacteur CVD conjointement avec un gaz porteur formé par un gaz inerte,
dans lequel des radicaux de la première substance de départ sont formés dans une réaction en phase gazeuse lesquels possèdent sous forme pure une température de décomposition,
les radicaux et la deuxième substance de départ sont amenés ensemble à la surface d'un substrat semiconducteur chauffé à une température de substrat qui est inférieure à la température de décomposition du radical pur,
dans lequel les radicaux réagissent dans une première réaction de manière exothermique avec le $SnCl_4$ à la surface, des atomes de Si, Ge et Sn restant à la surface comme produits de réaction et, simultanément à la première réaction, les radicaux se décomposent dans une deuxième réaction de manière endothermique par absorption de la chaleur libérée lors de la première réaction, dans lequel les radicaux formés dans la réaction en phase gazeuse ne réagissent avec l'halogénure dans la première réaction qu'à la surface de manière que la chaleur de réaction libérée lors de la réaction exothermique déclenche la deuxième réaction et entraîne une augmentation locale de la température à la surface de la couche ou du substrat au cours de laquelle les atomes de Si, Ge et Sn sont incorporés en agencement cristallin dans la surface,
et **caractérisé en ce qu'**il est formé une couche photoluminescente qui présente une proportion x de Sn comprise entre 0,1 et 0,14 et une proportion y de Si comprise entre 0 et 0,2.

**2.** Procédé selon la revendication 1, **caractérisé en ce que** les radicaux sont générés par détente pneumatique de la première substance gazeuse de départ lors de l'introduction dans la chambre de traitement d'une pression supérieure à 1000 mbar à une pression de chambre de traitement inférieure à 300 mbar.

**3.** Procédé selon l'une des revendications 1 ou 2, **caractérisé en ce que** l'hydrure est introduit dans la chambre de traitement à une pression partielle de 60 Pa à 120 Pa.

**4.** Procédé selon l'une des revendications 1 à 3, **caractérisé en ce que** l'halogénure est introduit dans la chambre de traitement avec une pression partielle de 0,1 % à 5 % de la pression partielle de l'hydrure, en particulier avec une pression partielle de 0,03 Pa à 1,25 Pa.

**5.** Procédé selon l'une des revendications 1 à 4, **caractérisé en ce que** la couche ou la succession de couches est déposée sur une couche tampon de Ge déposée sur un substrat de Si.

**6.** Procédé selon l'une des revendications 1 à 5, **caractérisé en ce que** la température du substrat se situe dans une plage comprise entre 350°C et 390°C.

**7.** Procédé selon l'une des revendications 1 à 6, **caractérisé en ce que** le dépôt de la couche ou de la succession de couches est effectué à une vitesse de croissance comprise entre 15 nm/min et 50 nm/min.

**8.** Composant optoélectronique, par exemple laser, photodiode, photocapteur, photoélément, guide de lumière ou similaire, fabriqué selon le procédé selon l'une des revendications précédentes, avec une couche monocristalline semi-conductrice de $Si_yGe_{1-x-y}Sn_x$ lumineuse par excitation, déposée par épitaxie sur une couche tampon de Ge d'un substrat de Si, avec une densité de dislocations à l'intérieur du volume de couche, c'est-à-dire en dehors d'une zone limitrophe de 10 nm à 20 nm à l'interface avec la couche tampon, inférieure à $10^6$ cm$^{-2}$.

**9.** Procédé selon l'une des revendications 1 à 7 ou composant optoélectronique selon la revendication 8, **caractérisé en ce que** la couche possède un degré de relaxation supérieur à 80 % et/ou la densité de dislocations est inférieure à $10^5$ cm$^2$ et/ou les défauts de réseau sont limités à une zone proche de la couche limitrophe avec la couche tampon, en particulier à une zone de 10 nm à 20 nm adjacente à la couche limitrophe.

**10.** Procédé selon l'une des revendications 1 à 7 ou 9 ou composant optoélectronique selon l'une des revendications 8 ou 9, **caractérisé en ce que** la succession de couches est une couche de GeSn agencée entre deux couches de SiGeSn.

**11.** Circuit intégré disposé sur un substrat, notamment microprocesseur, **caractérisé par** un composant optoélectronique disposé sur une couche tampon en liaison monolithique avec le substrat, selon l'une des revendications 9 à 10.

Fig. 1

Fig.2a

$586\ meV$

$536\ meV$

$Ge_{1-x}\ Sn_x$

$x=0,08$

Fig.2b

$458\ meV$

$486\ meV$

$x=0,13$

EP 3 155 145 B1

Fig. 3a    Fig. 3b    Fig. 3c    Fig. 3d

EP 3 155 145 B1

**_Fig. 4_**

| | |
|---|---|
| $Si_y\ Ge_{1-x-y}\ Sn_x\ n$ | |
| $Ge_{1-x-y}\ Sn_x$ | d |
| $Si_y\ Ge_{1-x-y}\ Sn_x\ p$ | |
| Ge   Puffer | |
| Si   Substrate | |

Fig. 5

**EP 3 155 145 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004034103 A1

- US 6200893 B


**In der Beschreibung aufgeführte Nicht-Patentliteratur**

- DEPOSITION OF HIGH QUALITY GaAs FILMS AT FAST RATES IN THE LP-CVD SYSTEM. *Journal of crystal grows,* 1989, vol. 94, 607-612
- **S. WIRTHS et al.** SiGeSn growth studies using reduced pressure chemical vapor deposition towards optoelectronic applications. *Thin Solid Films,* 2013
- Reduced Pressure CVD Growth of Ge and Ge1-xSnx Alloys. *ESC Journal of Solid State Science and Technology,* 2013, vol. 2 (5), N99-N102

- Band engineering and growth of tensile strained Ge/ (Si)GeSn heterostructures for tunnel field effect transistors. *Applied Physics Letters,* 2013, vol. 102, 192103
- Tensely strained GeSn alloys as optical gain media. *Applied Physics Letters,* 2013, vol. 103, 192110
- Low temperature RPCVD epitaxial growth of Si1-xGex using Si2H6 and Ge2H. *Solid-State Electronics,* 2013, vol. 83, 2-9
- Epitaxial Growth of Ge1-xSnx by Reduced Pressure CVD Using SnCl4 and Ge2H. *ECS Transactins,* 2012, vol. 50 (9), 885-893